# EUROPEAN PATENT APPLICATION

(11) **EP 4 009 370 A1**
(43) Date of publication of application: **08.06.2022**
(21) Application number: 20211819.6
(22) Date of filing: 04.12.2020
(51) Int. Cl.: H01L 27/22, G11C 19/08, G11C 11/16

(54) **RACETRACK MEMORY ARRAY WITH INTEGRATED MAGNETIC TUNNEL JUNCTION READER/PINNING SITE**

(71) Applicant: Max-Planck-Gesellschaft zur Förderung der Wissenschaften e.V., 80539 München (DE); Fraunhofer-Gesellschaft zur Förderung der angewandten Forschung e.V., 80686 München (DE)
(72) Inventor: WAGNER-REETZ, Maik, 01309 Dresden (DE); WISLICENUS, Marcus, 04769 Mügeln (DE); PARKIN, Stuart S.P., 06118 Halle (DE)
(74) Representative: Schweitzer, Klaus

(57) **Abstract**

A magnetic racetrack memory array device is disclosed which includes a racetrack layer on a magnetic tunnel junction (MTJ) layer over a metallization layer on a substrate. This approach allows for the manufacture of racetrack layers without damaging these layers during MTJ patterning.

## Description

The present invention relates to racetrack memory array devices, and more specifically, to a manufacturing method of racetrack memory arrays with integrated magnetic tunnel junction for read/write using CMOS technology.

### BACKGROUND

Racetrack memory (RTM) is a type of non-volatile magnetic memory that utilizes the current-controlled motion of magnetic domain walls (DW) in a thin strip or pillar of magnetic material, e.g., ferromagnetic material (e.g. US2011051490A1, US2014204647A1, US2014141530A1), that is the racetrack. Multiple magnetic domain walls are moved to and thro along the racetrack using current pulses passed into the racetrack. In typical configurations, a magnetic tunnel junction (MTJ) is located at a distinct location along the racetrack; the MTJ is used to read out the device by sensing the magnetization of the strip as domain walls are shifted along the racetrack. The most advantageous racetracks are formed from thin magnetic layers that have a significant perpendicular magnetic anisotropy (PMA) so that the magnetization either points out of or into the substrate. Thus, as the domain walls are moved the magnetization will change its orientation from being out of plane to being into the plane or vice versa. The MTJ can detect this change in orientation.

Typically, RTM manufacturing concepts involve its fabrication in the back end of line (BEOL). This conventional manufacturing technique starts with the layer having the magnetic domains, here referred to as the RT layer, which is typically followed by a layer for read and write units, here referred to as the MTJ layer. For interconnection, the read and write units are connected to the metallization layer. The RT layer is typically in the form of a series of parallel strips or racetracks that are closely spaced with each other and whose width is as small as possible consistent with the nano-fabrication techniques that are used to construct the RT layer.

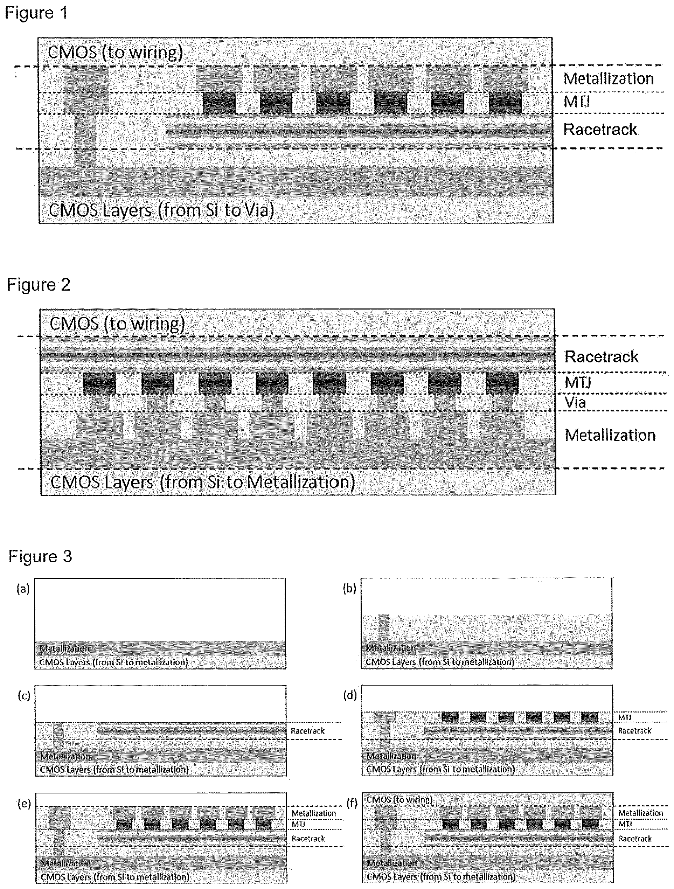

A typical state-of-the-art method of manufacturing the RTM is illustrated in figure 1. Typically, the racetrack is implemented in higher layers of the BEOL, which is due to the needed space for the RT layer itself. Figure 1 shows the MTJs arranged on top of the racetrack. Specifically, space-demanding metal lines are used to wire the corresponding MTJs. This state-of-the-art design increases the demand of space and area on the chip, going against the need in CMOS technology to use as low a space and area as possible.

Accordingly, such conventional RTM concepts using the above described manufacturing sequence suffer from:
- Problems with reducing the size of read and write units and, therefore, of the magnetic domains. This is a major problem of current RTM concepts since RTM performance increases with decreasing DW size. The RTM reaches limits for size reduction and density increase, which should be overcome. Yet, downscaling of RTM is advantageous since currents for DW motion can be decreased. It is needed for a lower energy consumption and for improved heat dissipation.
- Etch damage on RTM due to MTJ fabrication
   ∘ Increased Line Edge Roughness (LER) due to etch damage and therefore, increased unintended DW pinning. Increased DW pinning leads to degradation of the overall RTM performance.
   ∘ Resulting in MTJ performance degradation
   ∘ In the worst case loss of MTJ due to DW pinning center near the edges of the racetrack (RT). This can cause a fringing field mismatch, which would lead to a degradation of the overall RTM performance.
- The concept of using one transistor for controlling one MTJ - the so-called "1T-1MTJ concept" - is technically hardly feasible due to a very high effort for interconnection wiring.

It was therefore an object of the present invention to avoid or at least minimize the above shortcomings, and specifically to provide a manufacturing approach which allows for the manufacture of RT layers, without damaging these layers during MTJ formation.

### BRIEF DESCRIPTION OF THE INVENTION

In order to solve the above problems, the present invention fabricates the RT layer on top of the MTJ layer, with an optional but preferred Via layer which is located between the MTJ layer and an underlying metallization layer. Thus, the invention comprises a memory array device having the following layer sequence starting from the substrate:
- Substrate (including all CMOS layers from Si substrate to metallization),
- Metallization layer,
- Via layer (optional but preferred),
- MTJ layer,
- RT layer, including devices,
wherein a layer listed in the above sequence does not necessarily have to be in direct contact with its preceding or subsequent layer. Accordingly, within this inventive concept it is important that - starting from the preferred silicon substrate - the MTJ layer is manufactured prior to, i.e. before the RT layer, which does not necessarily mean that the RT layer is directly and immediately manufactured on top of the MTJ layer. Although this is preferred there may also be (an)other layer(s) between the MTJ layer and the RT layer.

According to the present invention, a "memory array device, which includes a racetrack layer" is equivalent to a Magnetic Random Access Memory (MRAM) and stores data in magnetic domains of a magnetic layer (e.g. ferromagnetic, ferrimagnetic, antiferromagnetic) but here arranged along racetracks.

The magnetic moments of such a magnetic layer (the RT layer) are magnetically coupled to the magnetic moments of a coplanar second layer via a Via layer which is sandwiched between the two magnetic layer, i.e. between the lowest magnetic layer of the RT layer and the topmost magnetic layer of the MTJ layer. This coupling can be achieved by use of a Via layer that becomes by proximity to the magnetic layers itself magnetic. This "proximity induced magnetization" is large in some transition metals, such as platinum and some of its alloys that almost satisfy the Stoner criterion for ferromagnetism. However, the proximity induced ferromagnetism is an "interface" effect that decays quickly into the interior of the Via layer. When the proximity induced moment goes to zero the coupling (a magnetic exchange coupling) also goes to zero. Thus, the Via layer must be thinner than this characteristic decay length, which in platinum, is 1 nm or less.

A typical RT layer consists of multiple layers which together form the RT layer. The basic structure of a racetrack is typically based on a ferromagnetic structure or a synthetic antiferromagnetic structure. The synthetic antiferromagnetic structure may be comprised of two ferromagnetic layers coupled antiferromagnetically via an antiferromagnetic coupling layer which is typically comprised of a transition metal like Ru or Ir. The ferromagnetic structure comprises one or more, preferably two or three layers of a ferromagnetic material which is typically selected from one or more of Co, Ni, or Fe or an alloy of Fe and/or Co, or an alloy of Ni that may further include one or more of Fe and Co. Typically, the racetrack structure has a total thickness in the range of 0.5 to 3.0 nm. Each individual layer of the racetrack structure may have a thickness in the range of 0.1 nm - 1.5 nm. The structure is composed of multiple thin magnetic layers so that the multilayered structure exhibits a PMA that is usually derived from the interfacial properties of the multilayered structure.

### BRIEF DESCRIPTION OF DRAWINGS

Figure 1 shows the layer sequence in a CMOS-compatible process scheme according to the state-of-the-art fabrication method for a RTM.
Figure 2 illustrates the concept of the present invention. It shows a dense MTJ array, on which the RT layer is fabricated. In this example a Via layer connects the MTJ array to the underlying metallization layer.
Figures 3 a-f illustrate the fabrication sequence of the individual layers in a conventional process scheme.

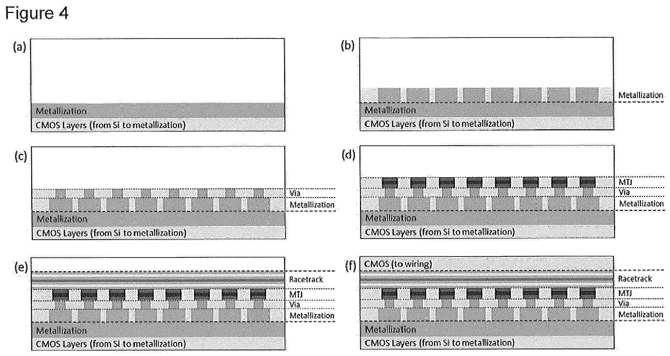

Figures 4 a-f illustrate the fabrication sequence of the individual layers in the process scheme according to the invention.

### DETAILED DESCRIPTION OF THE INVENTION

This present manufacturing approach allows the manufacture of the racetrack layer(s) without damaging these layers during MTJ formation. The present manufacturing approach can be regarded as an "inverted layer design"; the fabrication of an RTM in a flipped fashion. Optionally, a Via layer is processed on top of a metallization layer which preferably is already adapted to the design of the to be applied MTJs. Then, the MTJ layer is formed. The MTJ layer can be processed in a way so that etching stops in the passivation layer, which may be an oxide or nitride. Finally, the racetrack layers are formed so that they are arranged on top of the MTJs. Preferably typical CMOS technology is used for the manufacturing process (see e.g.: https://en.wikipedia.org/wiki/Semiconductor device fabrication). As an example, the RT layer can be fabricated using physical vapor deposition (PVD), such as cathodic arc deposition, electron-beam physical vapor deposition, evaporative deposition, close-space sublimation, pulsed laser deposition, magnetron sputter deposition, pulsed electron deposition, or the sublimation sandwich method.

In the conventional manufacturing design etching would stop in the RT layer. Using the manufacturing sequence according to the invention dramatically reduces RT layer etch damages. Moreover, the MTJs can be manufactured as a dense array, allowing for 1T-1MTJ interconnection and, thus, resulting in a drastically decreased effort for interconnection wiring. Every single MTJ can be used simultaneously as a pinning site, read unit and write unit.

In general within the framework of the present invention the RT layer(s) can be placed closer to the CMOS, which results in smaller DW sizes and, thus, higher density. This is due to the fact, that a dense metallization scheme can be processed closer to lower metallization layers. With a decrease in size the energy consumption per DW shift is decreased, which enables better heat dissipation. Additionally the speed of the device is enhanced due to a reduced RC delay as the length of the necessary metallization is shortened.

Finally, the present inventive concept allows for the MTJ bottom electrode to be polished which results in a decreased surface morphology and consequently enhances MTJ performance. This is conceptually not possible (because not allowed) with the conventional manufacturing approach.

## Claims

1. Memory array device, including a racetrack layer, having the following layer sequence starting from the substrate:
∘ Substrate,
∘ Metallization layer,
∘ MTJ layer,
∘ RT layer.

2. Memory array device according to claim 1, additionally including a Via layer between the metallization layer and the MTJ layer.

3. Memory array device according to claim 1 or 2, wherein the RT layer is based on a ferromagnetic structure or a synthetic antiferromagnetic structure.

4. Memory array device according to claim 3, wherein the synthetic antiferromagnetic structure is comprised of two ferromagnetic layers coupled antiferromagnetically via a coupling layer.

5. Memory array device according to claim 4, wherein the coupling layer is comprised of a transition metal.

6. Memory array device according to claim 3, wherein the ferromagnetic structure comprises one or more, preferably two or three layers of a ferromagnetic material which is selected from one or more of Co, Ni, or Fe or an alloy of Fe and/or Co, or an alloy of Ni that may further include one or more of Fe and Co.

7. Memory array device according to any one of claims 1 to 6, wherein the RT layer has a total thickness in the range of 0.5 to 3.0 nm.

8. Memory array device according to claim 7, wherein each individual layer of the RT layer has a thickness in the range of 0.1 nm - 1.5 nm.

9. Process for manufacturing a memory array device according to claim 1, comprising the steps of
∘ providing a substrate, then
∘ manufacturing a metallization layer on top of the substrate, then
∘ manufacturing an MTJ layer on top of the metallization layer and then
∘ manufacturing an RT layer on top of the MTJ layer.

10. Process according to claim 9, wherein a Via layer is manufactured between the metallization layer and the MTJ layer.
